# EUROPÄISCHE PATENTSCHRIFT

(11) **EP 1 616 069 B1**
(45) Veröffentlichungstag und Bekanntmachung des Hinweises auf die Patenterteilung: **29.11.2006**
(21) Anmeldenummer: 05716611.8
(22) Anmeldetag: 01.02.2005
(51) Int. Cl.: E05C 19/06, H05K 5/00, F16M 1/00

(54) **ANORDNUNG MIT EINER PLOMBE ZUM VERSCHLIESSEN EINER ÖFFNUNG EINES GEHÄUSES**
ARRANGEMENT COMPRISING A SEAL FOR CLOSING THE OPENING OF A HOUSING
DISPOSITIF DOTE D'UNE FERMETURE DE SECURITE POUR FERMER UNE OUVERTURE DE BOITIER

(30) Priorität: 09.02.2004 DE 102004006291
(43) Veröffentlichungstag der Anmeldung: 18.01.2006
(73) Patentinhaber: SIEMENS AKTIENGESELLSCHAFT, 80333 München (DE)
(72) Erfinder: GÖTZ, Jürgen, 78048 Villingen-Schwenningen (DE)
(86) Internationale Anmeldenummer: PCT/EP2005/050422
(87) Internationale Veröffentlichungsnummer: WO 2005/075772

(56) Entgegenhaltungen:
- EP-A- 0 090 921
- EP-A- 0 619 634
- DE-A1- 4 431 281
- FR-A- 2 810 018

## Beschreibung

Die Erfindung betrifft eine Plombe zum Verschließen einer Öffnung, wobei die Plombe in einer Einführrichtung in die Öffnung eingebracht wird, mit einem Grundkörper, mit einem seitlichen zur Einführrichtung hervorstehenden Vorsprung, der mittels einer Sollbruchstelle mit dem Grundkörper verbunden ist, welcher Vorsprung die Einführbewegung der Plombe in die Öffnung mittels Anlage an einer Anlagefläche begrenzt und bei fortgesetzter Einführbewegung im Anschluss an das Anliegen abschert, wobei der Grundkörper an der in Einführrichtung weisenden Seite mit einem Haken versehen ist, welcher mit einem korrespondierenden Rastvorsprung, der jenseitig der von der Grenzkontur der zu verschließenden Öffnung aufgespannten Ebene angeordnet ist, verrastbar ist. Daneben ist eine Anordnung mit einem Gehäuse Gegenstand der Erfindung, umfassend einen ersten Gehäuseteil und einen zweiten Gehäuseteil, welche Gehäuseteile zusammenfügbar sind, wobei der erste Gehäuseteil eine Öffnung aufweist, welche Öffnung im gefügten Zustand mittels einer Plombe verschlossen ist, die in einer Einführrichtung in die Öffnung eingebracht wird, wobei die Plombe einen Grundkörper aufweist, der mit einer Ausformung versehen ist, die formschlüssig die Bewegbarkeit der Plombe in die Einführrichtung begrenzt.

Eine sich in heutiger Technik häufig stellende Aufgabe liegt darin, Bauteile vor unbefugtem Zugriff zu schützen. Beispielsweise in der Kraftfahrzeug-Fahrtschreibertechnik werden Komponenten, die vor beabsichtigter oder ungewollter Manipulation zu schützen sind, in Gehäusen untergebracht, welche mittels Plomben versiegelt sind, so dass eine etwaige Manipulation stets nachweisbar ist.

Aus der Deutschen Offenlegungsschrift DE 32 12 255.1 A ist bereits eine Plombe und eine Anordnung der eingangs genannten Art bekannt. Ein entscheidender Nachteil der Anordnung besteht darin, dass insbesondere unter dem Einfluss hoher Kräfte die beiden mittels eines Schnapphakens einander befestigten Gehäusebauteile voneinander getrennt werden können, ohne eine der Plomben zu beschädigen. Daher ist die grundlegende Nachweisfunktion der Plombierung nicht unbedingt gegeben.

Ausgehend von den Problemen und Nachteilen des Standes der Technik liegt der Erfindung die Aufgabe zugrunde, eine Plombe bzw. eine Anordnung mit einer Plombe der eingangs genannten Art zu schaffen, die die geforderte Nachweisfunktion unter allen Umständen erfüllt. Erfindungsgemäß wird hierzu vorgeschlagen, die eingangs erstgenannte Plombe mit einem als Schnapphaken ausgebildeten Haken zu versehen. Ein entscheidender Vorteil der Erfindung liegt in der bestmöglichen und dennoch einfachen Befestigung der Plombe in der bestimmungsgemäßen Öffnung, so dass die Plombe beschädigungsfrei nicht mehr aus der Öffnung zu entfernen ist. Daneben sieht eine erfindungsgemäße Lösung der Aufgabe eine eingangs an zweiter Stelle genannte Anordnung vor, bei welcher die Plombe jenseitig der von der Grenzkontur der zu verschließenden Öffnung aufgespannten Ebene an dem zweiten Gehäuseteil befestigt ist. Erfolgt die Befestigung an dem zweiten Gehäuseteil, so kann das Gehäuse nicht mehr geöffnet werden bzw. die zu versiegelnde Öffnung nicht mehr von der Plombe befreit werden, ohne die Plombe zu beschädigen.

Eine zweckmäßige Weiterbildung der erfindungsgemäßen Plombe sieht vor, dass sich zwischen dem Grundkörper und dem Schnapphaken ein als Blattfeder ausgebildeter Abschnitt der Plombe erstreckt, so dass der Haken in einer Einschnapp-Richtung nachgiebig ist. Die Nachgiebigkeit des Schnapphakens mittels einer Blattfeder herzustellen, ist einerseits eine besonders kostengünstige Lösung, bietet aber auch andererseits neben der erforderlichen Stabilität eine besonders zweckmäßige Kinetik, da sich die Blattfeder als biegsam in einer Richtung jedoch starr in der senkrecht dazu orientierten Richtung erweist.

Die vorbeschriebene Anordnung mit einer Plombe kann eine formschlüssige, kraftschlüssige oder stoffflüssige Verbindung der Plombe mit dem zweiten Gehäuseteil vorsehen oder auch eine Kombination dieser Möglichkeiten, beispielsweise eine Klebung mit federndem Kraftschluss. Besonders zweckmäßig ist jedoch die form- und kraftschlüssige Verbindung der Plombe mit dem zweiten Gehäuseteil, wenn der Grundkörper der Plombe mit einem Haken versehen ist, welcher mit einem korrespondierenden Rastvorsprung an dem zweiten Gehäuseteil, der jenseitig der von der Grenzkontur der zu verschließenden Öffnung aufgespannten Ebene angeordnet ist, verrastbar ist. In ähnlicher Weist, wie die eingangs erstgenannte Plombe kann auch die Plombe bei Verwendung der erfindungsgemäßen Anordnung einen als Blattfeder ausgebildeten Abschnitt zwischen dem Schnapphaken und dem Grundkörper aufweisen, und daneben ist es auch möglich, dass der Rastvorsprung in gleicher Weise federnd ausgebildet ist. Zweckmäßig ist der Haken an dem in Einführrichtung vorderen Ende des Grundkörpers angeordnet.

Eine besonders zweckmäßige Anwendung der Anordnung nach der Erfindung ergibt sich, wenn das erste Gehäuseteil mindestens eine Befestigungsanordnung zum Befestigen des zweiten Gehäuseteiles aufweist und das Gehäuse im Bereich einer jeden Befestigungsanordnung eine Öffnung aufweist, durch welche sich der Schnapphaken entriegeln lässt, wobei diese Öffnung mittels der Plombe verschlossen ist. Besonders zweckmäßig ist hierbei eine Ausgestaltung der Erfindung, bei der es unter denen mehrere Öffnungen verschließenden Plomben wenigstens eine Plombe einer ersten Art und eine Plombe einer zweiten Art gibt, wobei die Plombe erster Art an dem ersten Gehäuseteil gegen eine Bewegung entgegen der Einführrichtung gesichert ist, und die Plombe zweiter Art an dem zweiten Gehäuseteil gegen eine Bewegung entgegen der Einführrichtung gesichert ist. Auf diese Weise muss in jedem Fall die Plombe der zweiten Art beim Trennen der Gehäuseteile beschädigt werden. Auch hier ist die Plombe zweiter Art zweckmäßig mittels eines Schnapphakens an dem zweiten Gehäuseteil befestigt. In gleicher Weise sind die Befestigungsanordnungen zwischen den beiden Gehäuseteilen vorteilhaft als zueinander zugeordnete Schnapphaken und Rastvorsprünge ausgebildet.

Mit Vorteil ist die Bewegbarkeit der Plombe in Einführrichtung in der Weise eingeschränkt, dass die Ausformung an dem Grundkörper als seitlich zur Einführrichtung hervorstehender Vorsprung ausgebildet ist, der mittels einer Sollbruchstelle mit dem Grundkörper verbunden ist, welcher Vorsprung die Einführbewegung der Plombe in die Öffnung mittels Anlage an einer Anlagefläche begrenzt und bei fortgesetzter Einführbewegung im Anschluss an die Anlage abschert.

Um den nicht nachweisbaren Zugriff auf das Gehäuseinnere weitergehend zu erschweren, ist es zweckmäßig, wenn die Plomben der ersten Art und die Plomben der zweiten Art, die jeweils eine Öffnung an dem Gehäuse verschließen, beide einen Sichtbereich aufweisen, den ein Betrachter im gefügten Zustand von außen sehen kann und einen Nicht-Sichtbereich, den der Betrachter im gefügten Zustand von außen nicht sehen kann, und die Sichtbereiche der beiden Plombentypen identisch ausgebildet sind.

Da die Plombe zweiter Art dem für ein Versiegelungsbauteil typischen Zwiespalt zwischen der sicheren Nachweisfunktion einerseits und der Langlebigkeit und dem sicheren Sitz an dem Bestimmungsort andererseits unterliegt, ist es zweckmäßig, wenn seitlich der Öffnung an dem ersten Gehäuseteil jenseitig der von Begrenzungskontur der Öffnung aufgespannten Ebene ein Führungselement angeordnet ist, welches den als Blattfeder ausgebildeten Abschnitt der Plombe versteifend unterstützt. Auf diese weise kann für die Plombe ein Werkstoff gewählt werden, der nur geringe Festigkeitseigenschaften aufweist.

Als besonders zweckmäßig hat sich eine Ausbildung der Plombe erster Art bei der erfindungsgemäßen Anordnung erwiesen, welche unter Abscherung des seitlichen Vorsprungs eine Entriegelung der Befestigungsanordnung bewirkt, wenn die Einführbewegung nach Anlage des seitlichen Vorsprungs an der Anlagefläche fortgesetzt wird. In der Folge wird die Erfindung anhand eines speziellen Ausführungsbeispiels unter Bezugnahme auf Zeichnungen näher erläutert, wobei die Erfindung nicht auf die Darstellungen dieses Beispiels beschränkt ist. Es zeigen:
- Figur 1: eine dreidimensionale Darstellung eines ersten Gehäuseteiles und zweiten Gehäuseteiles (Frontring) mit erfindungsgemäßen Plomben von der Rückseite,
- Figur 2: das in Figur 1 dargestellte Bauteil ohne zweitem Gehäuseteil (Frontring) von der Vorderseite,
- Figur 3: eine dreidimensionale Zusammenstellung eines ersten Gehäuseteiles, eines zweiten Gehäuseteiles und einer Plombe erster Art,
- Figur 4: eine Schnittdarstellung der Zusammenstellung der Figur 3,
- Figur 5 und 6: jeweils eine Schnittdarstellung einer Zusammenstellung eines ersten Gehäuseteiles, eines zweiten Gehäuseteiles und einer Plombe zweiter Art gemäß der Erfindung.

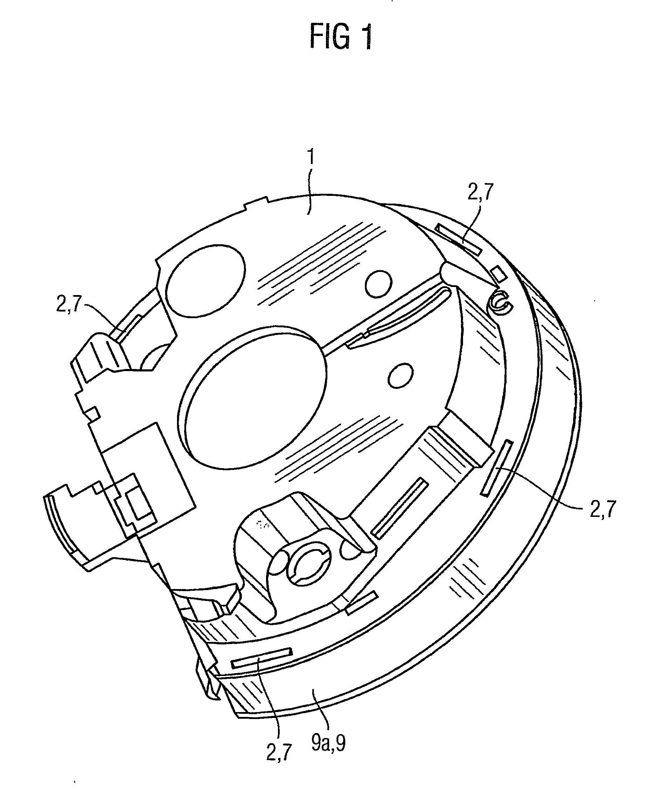

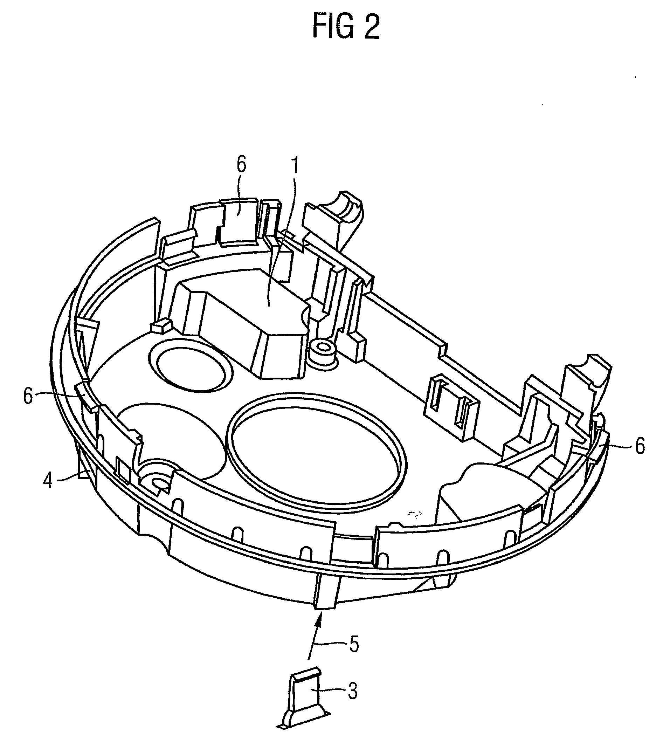

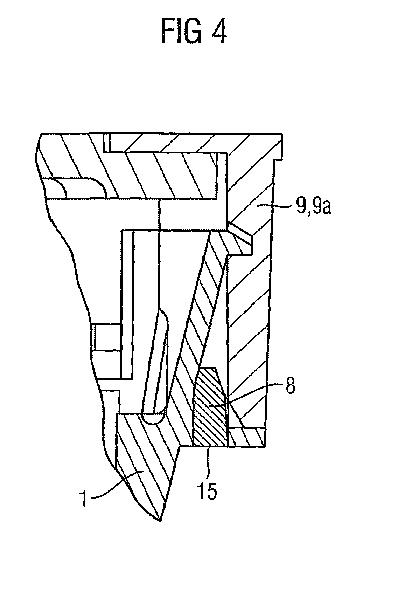

In den Figuren 1 und 2 ist ein erstes Gehäuseteil 1 dargestellt, welches als rückseitiger Gehäusedeckel ausgebildet ist, wobei die Darstellung der Figur 1 noch einen Frontring 9a eines zweiten Gehäuseteiles 9 umfasst. Aus der rückwärtigen Perspektive der Figur 1 sind deutlich längliche, schlitzartig ausgebildete Öffnungen 2 erkennbar, in welche erfindungsgemäße Plomben zweiter Art 3 und Plomben erster Art 4 in erfindungsgemäßer Anordnung in einer Einführrichtung 5 einführbar sind. Über den Umfang des ersten Gehäuseteiles 1 sind, wie in Figur 2 erkennbar, Befestigungsanordnungen 6 innenseitig vorgesehen, die mit korrespondierenden Mitteln an einem nicht dargestellten zweiten Gehäuseteil das Gesamtgehäuse zusammenhaltend zusammenwirken. Die Befestigungsanordnungen 6 sind als federnde Schnapphaken ausgebildet. Figur 1 zeigt den Sichtbereicht 7 der Plomben erster Art 4 und der Plomben zweiter Art 3, der identisch ausgebildet ist, wohingegen der in den Figuren 4, 5 und 6 gezeigte Nicht-Sichtbereich 8 bei den Plomben erster Art 4 unterschiedlich zu den Plomben zweiter Art 3 ist.

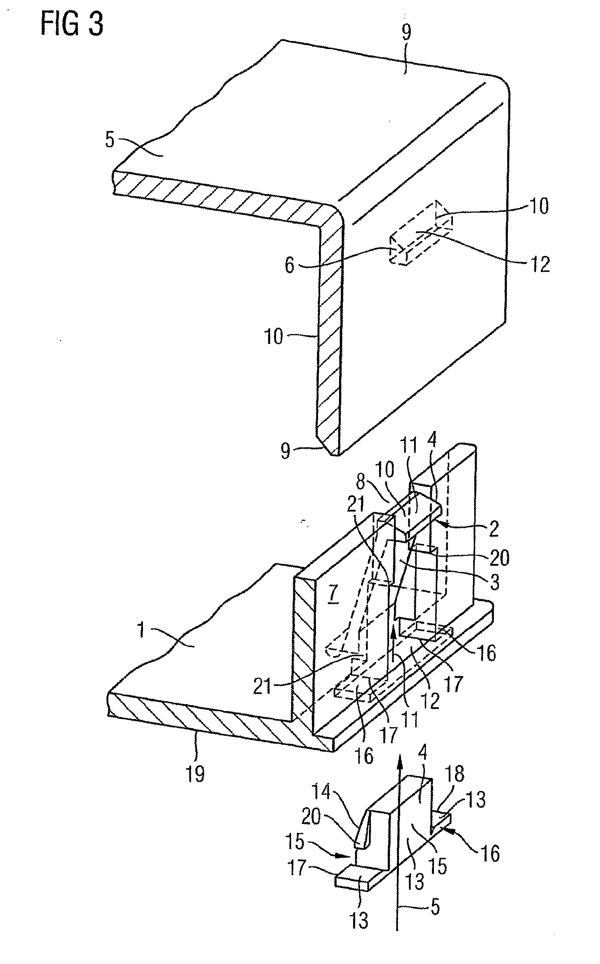

Die Figuren 3 und 4 zeigen die Anordnung einer Plombe erster Art 4 an einem ersten Gehäuseteil 1 und einem zweiten Gehäuseteil 9 im Detail. Die beiden Gehäuseteile 1, 9 sind mittels einer als Rastverbindung 10 ausgebildeten Befestigungsanordnung 6zusammengehalten, wobei an dem ersten Gehäuseteil die Befestigungsanordnung 6 als federnder Rasthaken 11 ausgebildet ist, der mit einer korrespondierenden Ausnehmung 12 an einem zweiten Gehäuseteil 9 haltend zusammenwirkt. Seitlich des Rasthakens 11 ist eine Öffnung 2 vorgesehen, die mittels einer Plombe erster Art 4 verschließbar ist. Die Plombe erster Art 4 ist mit zwei seitlich und im Wesentlichen senkrecht zur Einführrichtung 5 hervorstehenden Vorsprüngen 13 versehen, die mittels einer Sollbruchstelle 14 mit einem Grundkörper 15 der Plombe verbunden sind. In der Endposition der Montage kommen die seitlich hervorstehenden Vorsprünge 13 an jeweils einer Anlagefläche 16 an dem ersten Gehäuseteil 1 zur Anlage. Wird die Plombe erster Art 4 in Einführrichtung 5 weiter hineingedrückt, kommt es zur Abscherung der Vorsprünge 13 im Bereich der Sollbruchstellen 14 mittels an den Anlageflächen 16 vorgesehenen Kanten 17. Der Grundkörper 15 der Plombe erster Art 4 ist mit zwei seitlichen Widerhaken 20 versehen, die in korrespondierende Aussparungen 21 an dem ersten Gehäuseteil 1 in der verschließenden Endposition einrasten. Wird die Plombe erster Art 4 aus der verschlie-ßenden Endposition weiter in Einführrichtung 5 bewegt, bewirkt dies ein Ausrücken des Rasthakens 11 aus der Ausnehmung 12, was die Demontage der beiden Gehäuseteile vereinfacht und gleichzeitig die Nachweisfunktion des Öffnens mittels der Plombe 4 gewährleistet. Gelingt es, den Rasthaken 11 aus seiner Halteposition herauszubewegen, ohne die Plombe erster Art 4 zu entfernen, ist das Gehäuseinnere auch ohne Beschädigung der Plombe 4 zugänglich.

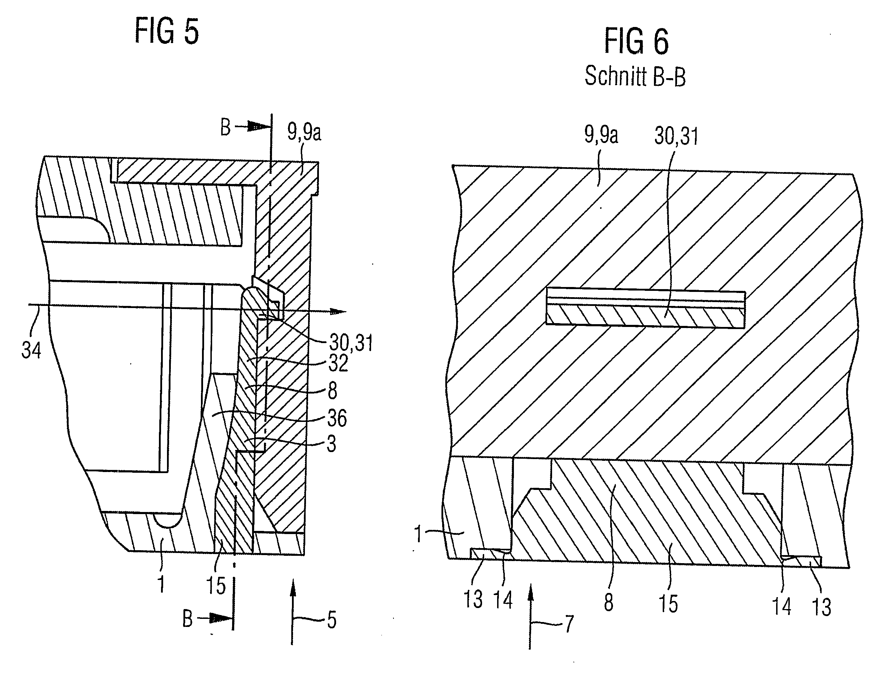

Die Figuren 5 und 6 zeigen die Funktionsweise und Ausgestaltung einer erfindungsgemäßen Plombe zweiter Art 3. Die erfindungsgemäße Plombe zweiter Art 3 weist ebenso wie die Plombe erster Art 4 einen Grundkörper 15, zwei seitliche Vorsprünge 13, die mittels einer Sollbruchstelle 14 an dem Grundkörper angebunden sind, auf. An dem in Einschnapprichtung 5 führenden Ende des Grundkörpers 15 weist die Plombe zweiter Art 3 einen Schnapphaken 30 auf, der endseitig einen Haken 31 verrastbar mit einem Rastvorsprung an dem zweiten Gehäuseteil 9 besitzt. Der Schnapphaken ist mittels eines Blattfederabschnittes 32 an dem Grundkörper 15 befestigt, so dass der Haken 31 in einer Einschnapp-Richtung 34 nachgiebig ist. Das erste Gehäuseteil 1 ist mit einer den Blattfederabschnitt 33 der Plombe zweiter Art 3 unterstützenden federnden Führung 36 versehen, so dass der Haken 31 an dem Rastvorsprung 32 sicher verankert ist. Die Befestigung der Plombe zweiter Art 3 an dem zweiten Gehäuseteil 9 bewirkt, dass die Plombe zweiter Art 3 relativ zu dem zweiten Gehäuseteil 9 nicht entgegen der Einschubrichtung 5 bewegt werden kann, ohne sie zu zerstören. Auf diese Weise hat jede Trennung der beiden Gehäuseteile 1, 9 eine Zerstörung der Plombe zweiter Art 3 zur Folge.

## Patentansprüche

1. Plombe (3) zum Verschließen einer Öffnung (2), wobei die Plombe (3) in einer Einführrichtung (5) in die Öffnung (2) eingebracht wird, mit einem Grundkörper (15), mit einem seitlichen zur Einführrichtung (5) hervorstehenden Vorsprung (13), der mittels einer Sollbruchstelle (14) mit dem Grundkörper (15) verbunden ist, welcher Vorsprung (13) die Einführbewegung der Plombe (3) in die Öffnung (2) mittels Anlage an einer Anlagefläche (16) begrenzt und bei fortgesetzter Einführbewegung im Anschluss an das Anliegen abschert, wobei der Grundkörper (15) an der in Einführrichtung (5) weisenden Seite mit einem Haken (31) versehen ist, welcher mit einem korrespondierenden Rastvorsprung (32), der jenseitig der von der Grenzkontur der zu verschließenden Öffnung (2) aufgespannten Ebene angeordnet ist, verrastbar ist, **dadurch gekennzeichnet, dass** der Haken (31) als Schnapphaken (30) ausgebildet ist.

2. Plombe nach Anspruch 1, **dadurch gekennzeichnet, dass** sich ein als Blattfeder ausgebildeter Abschnitt (33) der Plombe zwischen dem Grundkörper (15) und dem Schnapphaken (30) (3) erstreckt, so dass der Haken (31) in einer Einschnapp-Richtung (34) nachgiebig ist.

3. Anordnung mit einem Gehäuse, umfassend einen ersten Gehäuseteil (1) und einen zweiten Gehäuseteil (9), welche Gehäuseteile (1, 9) zusammenfügbar sind, wobei der erste Gehäuseteil (1) eine Öffnung (2) aufweist, wobei die Öffnung (2) im gefügten Zustand mittels einer Plombe (3) verschlossen ist, die in einer Einführrichtung (5) in die Öffnung (2) eingebracht wird, die Plombe (3) einen Grundkörper (15) aufweist, der mit einer Ausformung versehen ist, die formschlüssig die Bewegbarkeit der Plombe in die Einführrichtung begrenzt, **dadurch gekennzeichnet, dass** die Plombe (3) jenseitig der von der Grenzkontur der zu verschließenden Öffnung (2) aufgespannten Ebene an dem zweiten Gehäuseteil (9) befestigt ist.

4. Anordnung nach Anspruch 3, **dadurch gekennzeichnet, dass** der Grundkörper (15) der Plombe (3) mit einem Haken (31) versehen ist, welcher mit einem korrespondierenden Rastvorsprung (32) an dem zweiten Gehäuseteil (9), der jenseitig der von der Grenzkontur der zu verschließenden Öffnung (2) aufgespannten Ebene angeordnet ist, verrastbar ist.

5. Anordnung nach Anspruch 4, **dadurch gekennzeichnet, dass** der Haken (31) sich an dem in Einführrichtung (5) vorderen Ende des Grundköpers (15) befindet.

6. Anordnung nach Anspruch 5, **dadurch gekennzeichnet, dass** der Haken (31) als Schnapphaken (30) ausgebildet ist.

7. Anordnung nach Anspruch 6, **dadurch gekennzeichnet, dass** sich bei der mit Schnapphaken (30) versehenen Plombe (3) zwischen dem Grundkörper (15) und dem Schnapphaken (30) ein als Blattfeder ausgebildeter Abschnitt (33) der Plombe (3) erstreckt, so dass der Haken (31) in einer Einschnapp-Richtung (34) nachgiebig ist.

8. Anordnung nach einem der Ansprüche 3 bis 7, **dadurch gekennzeichnet, dass** das erste Gehäuseteil (1) mindestens eine Befestigungsanordnung (6) zum Befestigen des zweiten Gehäuseteils (9) aufweist und das Gehäuse im Bereich der Befestigungsanordnung (6) eine Öffnung (2) aufweist, durch welche sich der Schnapphaken (30) entriegeln lässt, wobei diese Öffnung (2) mittels einer Plombe (3, 4) verschlossen ist, die in einer Einführrichtung (5) in die Öffnung (2) eingebracht wird, einen Grundkörper (15) aufweist, der mit einer Ausformung versehen ist, die formschlüssig die Bewegbarkeit der Plombe in die Einführrichtung begrenzt.

9. Anordnung nach Anspruch 8, **dadurch gekennzeichnet, dass** es unter den die Öffnungen (2) verschließenden Plomben (3, 4) wenigstens ein Plombe (4) erster Art und eine Plombe (3) zweiter Art gibt, wobei die Plombe (4) erste Art an dem ersten Gehäuseteil (1) gegen eine Bewegung entgegen der Einführrichtung (5) gesichert ist und die Plombe (3) zweiter Art an dem zweiten Gehäuseteil (9) gegen eine Bewegung entgegen der Einführrichtung (5) gesichert ist.

10. Anordnung nach Anspruch 3 oder 8, **dadurch gekennzeichnet, dass** die Ausformung an dem Grundkörper als seitlich zur Einführrichtung (5) hervorstehender Vorsprung (13) ausgebildet ist, der mittels einer Sollbruchstelle (14) mit dem Grundkörper (15) verbunden ist, welcher Vorsprung (13) die Einführbewegung der Plombe (3) in die Öffnung (2) mittels Anlage an einer Anlagefläche (16) begrenzt und bei fortgesetzter Einführbewegung im Anschluss an die Anlage abschert.

11. Anordnung nach Anspruch 8, **dadurch gekennzeichnet, dass** die Befestigungsanordnung (6) mindestens einen Schnapphaken (30) an dem ersten Gehäuseteil (1) aufweist und ein zweiter Gehäuseteil (9) mindestens einen mit diesem Schnapphaken (30) korrespondierenden Rastvorsprung (32).

12. Anordnung nach Anspruch 8, **dadurch gekennzeichnet, dass** die Plombe (3) zweiter Art mittels eines als Schnapphaken (30) ausgebildeten Hakens (31), der mit dem Rastvorsprung (32) an dem zweiten Gehäuseteil (9) verrastbar ist, gegen eine Bewegung entgegen der Einführrichtung (5) gesichert ist.

13. Anordnung nach Anspruch 12, **dadurch gekennzeichnet, dass** der Grundkörper (15) der Plombe (3) zweiter Art an dem in Einführrichtung (5) weisenden Ende mit dem Schnapphaken (30) versehen ist.

14. Anordnung nach Anspruch 13, **dadurch gekennzeichnet, dass** sich bei der Plombe (3) zweiter Art zwischen dem Grundkörper (15) und dem Schnapphaken (30) ein als Blattfeder ausgebildeter Abschnitt (33) der Plombe (4) erstreckt, so dass der Haken (31) in einer Einschnapp-Richtung (34) nachgiebig ist.

15. Anordnung nach einem der Ansprüche 8 bis 14, **dadurch gekennzeichnet , dass** mindestens eine Plombe (4) erster Art und eine Plombe (3) zweiter Art jeweils eine Öffnung (2) an dem Gehäuse verschließen, wobei beide Plomben (4, 3) einen Sichtbereich (7) aufweisen, den ein Betrachter im gefügten Zustand von außen sehen kann und einen Nicht-Sichtbereich (8), den der Betrachter im gefügten Zustand von außen nicht sehen kann und die Sichtbereiche (7) der ersten und der zweiten Plombe (4, 3) identisch ausgebildet sind.

16. Anordnung nach Anspruch 14, **dadurch gekennzeichnet, dass** seitlich der Öffnung (2) an dem ersten Gehäuseteil (1) ein Führungselement (36) angeordnet ist, welches den als Blattfeder ausgebildeten Abschnitt (33) versteifend unterstützt.

17. Anordnung gemäß Anspruch 9, **dadurch gekennzeichnet, dass** eine fortgesetzte Einführbewegung der Plombe (4) erster Art unter Abscherung des seitlichen Vorsprungs (13) eine Entriegelung der Befestigungsanordnung (6) bewirkt, dessen Öffnung (2) zur Entriegelung mittels der Plombe (4) verschlossen ist.

## Claims

1. Lead seal (3) for sealing an opening (2), the lead seal (3) being introduced into the opening (2) in an insertion direction (5), having a base body (15), having a lateral projection (13) which protrudes towards the insertion direction (5) and is connected to the base body (15) by means of a desired breaking point (14), which projection (13) limits the insertion movement of the lead seal (3) into the opening (2) by means of bearing against a bearing face (16) and shaves off after this bearing when there is a continued insertion movement, the base body (15) being provided, on the side pointing in the insertion direction (5), with a hook (31) which can be latched with a corresponding latching projection (32) which is arranged opposite the plane enclosed by the limiting contour of the opening (2) to be sealed, **characterized in that** the hook (31) is in the form of a snap hook (30).

2. Lead seal according to Claim 1, **characterized in that** a section (33), in the form of a leaf spring, of the lead seal extends between the base body (15) and the snap hook (30) (3) such that the hook (31) is flexible in a snap-in direction (34).

3. Arrangement having a housing, comprising a first housing part (1) and a second housing part (9), which housing parts (1, 9) can be joined together, the first housing part (1) having an opening (2), the opening (2) being sealed, in the joined state, by means of a lead seal (3) which is introduced into the opening (2) in an insertion direction (5), the lead seal (3) having a base body (15) which is provided with a shaped section which limits, in an interlocking manner, the ability of the lead seal to move in the insertion direction, **characterized in that** the lead seal (3) is fixed to the second housing part (9) opposite the plane enclosed by the limiting contour of the opening (2) to be sealed.

4. Arrangement according to Claim 3, **characterized in that** the base body (15) of the lead seal (3) is provided with a hook (31) which can be latched with a corresponding latching projection (32) on the second housing part (9) which is arranged opposite the plane enclosed by the limiting contour of the opening (2) to be sealed.

5. Arrangement according to Claim 4, **characterized in that** the hook (31) is located at that end of the base body (15) which is at the front in the insertion direction (5).

6. Arrangement according to Claim 5, **characterized in that** the hook (31) is in the form of a snap hook (30).

7. Arrangement according to Claim 6, **characterized in that** in the case of the lead seal (3) provided with the snap hook (30), a section (33), in the form of a leaf spring, of the lead seal (3) extends between the base body (15) and the snap hook (30) such that the hook (31) is flexible in a snap-in direction (34).

8. Arrangement according to one of Claims 3 to 7,
**characterized in that** the first housing part (1) has at least one fixing arrangement (6) for the purpose of fixing the second housing part (9), and the housing has, in the region of the fixing arrangement (6), an opening (2), by means of which the snap hook (30) can be unlatched, this opening (2) being sealed by means of a lead seal (3, 4) which is introduced into the opening (2) in an insertion direction (5) and has a base body (15) which is provided with a shaped section which limits, in an interlocking manner, the ability of the lead seal to move in the insertion direction.

9. Arrangement according to Claim 8, **characterized in that** there is at least one lead seal (4) of the first type and a lead seal (3) of the second type amongst the lead seals (3, 4) sealing the openings (2), the lead seal (4) of the first type being secured on the first housing part (1) against a movement counter to the insertion direction (5), and the lead seal (3) of the second type being secured on the second housing part (9) against a movement counter to the insertion direction (5).

10. Arrangement according to Claim 3 or 8, **characterized in that** the shaped section is formed on the base body as a projection (13) which protrudes laterally with respect to the insertion direction (5) and is connected to the base body (15) by means of a desired breaking point (14), which projection (13) limits the insertion movement of the lead seal (3) into the opening (2) by means of bearing against a bearing face (16) and shaves off after this bearing when there is a continued insertion movement.

11. Arrangement according to Claim 8, **characterized in that** the fixing arrangement (6) has at least one snap hook (30) on the first housing part (1), and a second housing part (9) has at least one latching projection (32) corresponding to this snap hook (30).

12. Arrangement according to Claim 8, **characterized in that** the lead seal (3) of the second type is secured against a movement counter to the insertion direction (5) by means of a hook (31) which is in the form of a snap hook (30) and can be latched with the latching projection (32) on the second housing part (9).

13. Arrangement according to Claim 12, **characterized in that** the base body (15) of the lead seal (3) of the second type is provided with the snap hook (30) at the end pointing in the insertion direction (5).

14. Arrangement according to Claim 13, **characterized in that**, in the case of the lead seal (3) of the second type, a section (33), in the form of a leaf spring, of the lead seal (4) extends between the base body (15) and the snap hook (30) such that the hook (31) is flexible in a snap-in direction (34).

15. Arrangement according to one of Claims 8 to 14,
**characterized in that** at least one lead seal (4) of the first type and a lead seal (3) of the second type each seal an opening (2) in the housing, the two lead seals (4, 3) having a visible region (7) which can be seen by an observer from the outside in the joined state, and an invisible region (8) which cannot be seen by the observer from the outside in the joined state, and the visible regions (7) of the first and the second lead seal (4, 3) being of identical design.

16. Arrangement according to Claim 14, **characterized in that** a guide element (36), which supports the section (33) in the form of a leaf spring in a reinforcing manner, is arranged to the side of the opening (2) on the first housing part (1).

17. Arrangement according to Claim 9, **characterized in that** a continued insertion movement of the lead seal (4) of the first type, as the lateral projection (13) shaves off, brings about unlatching of the fixing arrangement (6), whose opening (2) is sealed by means of the lead seal (4) for unlatching purposes.

## Revendications

1. Plomb de sécurité (3) destiné à fermer une ouverture (2), où le plomb de sécurité (3) est mis en place dans l'ouverture (2) dans un sens d'introduction (5), le plomb de sécurité comportant un corps de base (15) avec un épaulement (13), qui fait saillie latéralement par rapport à la direction d'introduction (5) et qui est lié au corps de base (15) par l'intermédiaire d'un point (14) destiné à la rupture, cet épaulement (13) limitant le mouvement d'introduction du plomb de sécurité (3) dans l'ouverture (2) en s'appliquant sur une surface de butée (16) et étant cisaillé, si le mouvement d'introduction se poursuit après l'application de l'épaulement sur la surface de butée, le corps de base (15) étant doté, sur le côté dirigé dans le sens d'introduction (5), d'un crochet (31) pouvant s'encliqueter dans un épaulement d'arrêt correspondant (32), qui est disposé de l'autre côté du plan formé par le contour de bordure de l'ouverture (2) à fermer, **caractérisé par le fait que** le crochet (31) est conçu comme crochet à ressort (30).

2. Plomb de sécurité selon la revendication 1, **caractérisé par le fait qu'**une partie (33) du plomb de sécurité conçue comme ressort à lame s'étend entre le corps de base (15) et le crochet à ressort (30), si bien que le crochet (31) est déformable dans une direction d'accrochage (34).

3. Système comportant un boîtier qui se compose d'une première partie (1) et d'une deuxième partie (9), ces parties de boîtier (1, 9) pouvant être assemblées, où la première partie (1) du boîtier comporte une ouverture (2), l'ouverture (2) étant fermée, dans l'état assemblé, par un plomb de sécurité (3), qui est mis en place dans l'ouverture (2) dans un sens d'introduction (5), le plomb de sécurité (3) comportant un corps de base (15) qui est doté d'une configuration limitant en assemblage géométrique la mobilité du plomb de sécurité dans la direction d'introduction, **caractérisé par le fait que** le plomb de sécurité (3) est fixé, de l'autre côté du plan formé par le contour de bordure de l'ouverture (2) à fermer, à la deuxième partie (9) du boîtier.

4. Système selon la revendication 3, **caractérisé par le fait que** le corps de base (15) du plomb de sécurité (3) est doté d'un crochet (31) ) pouvant s'encliqueter dans un épaulement d'arrêt correspondant (32) sur la deuxième partie (9) du boîtier, laquelle est disposée de l'autre côté du plan formé par le contour de bordure de l'ouverture (2) à fermer.

5. Système selon la revendication 4, **caractérisé par le fait que** le crochet (31) se trouve à l'extrémité avant du corps de base (15) dans le sens d'introduction (5).

6. Système selon la revendication 5, **caractérisé par le fait que** le crochet (31) est conçu comme crochet à ressort (30).

7. Système selon la revendication 6, **caractérisé par le fait que**, sur le plomb de sécurité (3) doté du crochet à ressort (30), une section (33) du plomb de sécurité (3) s'étend entre le corps de base (15) et le crochet à ressort (30), de telle manière que le crochet (31) est déformable dans un sens d'accrochage (34).

8. Système selon l'une des revendications 3 à 7, **caractérisé par le fait que** la première partie (1) du boîtier comporte au moins un dispositif de fixation (6) permettant de fixer la deuxième partie (9) du boîtier et que le boîtier comporte, dans la zone du dispositif de fixation (6), une ouverture (2), à travers laquelle il est possible de déverrouiller le crochet à ressort (30), cette ouverture (2) étant fermée par un plomb de sécurité (3, 4), qui est mis en place dans l'ouverture (2) dans un sens d'introduction (5), qui comporte un corps de base (15), lequel est doté d'une configuration limitant en assemblage géométrique la mobilité du plomb de sécurité dans la direction d'introduction.

9. Système selon la revendication 8, **caractérisé par le fait que**, parmi les plombs de sécurité (3, 4) fermant les ouvertures (2), il y a au moins un plomb de sécurité (4) d'un premier genre et un plomb de sécurité (3) d'un deuxième genre, le plomb de sécurité (4) du premier genre étant protégé sur la première partie (1) du boîtier contre un mouvement à l'encontre de la direction d'introduction (5) et le plomb de sécurité (3) du deuxième genre étant protégé sur la deuxième partie (9) du boîtier contre un mouvement à l'encontre de la direction d'introduction (5).

10. Système selon la revendication 3 ou 8, **caractérisé par le fait que** la configuration sur le corps de base est conçue comme épaulement (13), qui fait saillie latéralement par rapport à la direction d'introduction (5) et qui est lié au corps de base (15) par l'intermédiaire d'un point (14) destiné à la rupture, cet épaulement (13) limitant le mouvement d'introduction du plomb de sécurité (3) dans l'ouverture (2) en s'appliquant sur une surface de butée (16) et étant cisaillé, si le mouvement d'introduction se poursuit après l'application de l'épaulement sur la surface de butée.

11. Système selon la revendication 8, **caractérisé par le fait que** le dispositif de fixation (6) comporte au moins un crochet à ressort (30) sur la première partie (1) du boîtier et qu'une deuxième partie (9) du boîtier comporte au moins un épaulement d'arrêt (32) correspondant à ce crochet à ressort (30).

12. Système selon la revendication 8, **caractérisé par le fait que** le plomb de sécurité (3) du deuxième genre est protégé, au moyen d'un crochet (31) conçu comme crochet à ressort (30), qui peut s'encliqueter avec l'épaulement d'arrêt (32) sur la deuxième partie (9) du boîtier, contre un mouvement à l'encontre de la direction d'introduction (5).

13. Système selon la revendication 12, **caractérisé par le fait que** le corps de base (15) du plomb de sécurité (3) du deuxième genre est doté, à l'extrémité tournée dans la direction d'introduction (5), d'un crochet à ressort (30).

14. Système selon la revendication 13, **caractérisé par le fait que**, dans le cas du plomb de sécurité (3) du deuxième genre, une partie (33) du plomb de sécurité (4) conçue comme ressort à lame s'étend entre le corps de base (15) et le crochet à ressort (30), si bien que le crochet (31) est déformable dans une direction d'accrochage (34).

15. Système selon l'une des revendications 8 à 14, **caractérisé par le fait que** au moins un plomb de sécurité (4) du premier genre et un plomb de sécurité (3) du deuxième genre ferment chacun une ouverture (2) dans le boîtier, les deux plombs (4, 3) comportant une partie visible (7), qu'un observateur peut, dans l'état assemblé, voir de l'extérieur, et une partie non visible (8), que l'observateur ne peut pas, dans l'état assemblé, voir de l'extérieur, et les parties visibles (7) du premier et du deuxième plomb de sécurité (4, 3) étant conçus d'une façon identique.

16. Système selon la revendication 14, **caractérisé par le fait que**, sur le côté de l'ouverture (2) sur la première partie (1) du boîtier, est disposé un organe de guidage (36) qui renforce en la rendant rigide la section (33) conçue comme ressort à lame.

17. Système selon la revendication 9, **caractérisé par le fait qu'**une poursuite du mouvement d'introduction du plomb de sécurité (4) du premier genre provoque, par cisaillement de l'épaulement latéral (13), un déverrouillage du dispositif de fixation (6), dont l'ouverture (2) destinée au déverrouillage est fermée au moyen du plomb de sécurité (4).
